# FASCICULE DE BREVET EUROPEEN

(11) **EP 1 629 598 B1**
(45) Date de publication et mention de la délivrance du brevet: **10.08.2011**
(21) Numéro de dépôt: 04767219.1
(22) Date de dépôt: 01.06.2004
(51) Int. Cl.: H03K 17/08, H03K 17/18

(54) **ETAGE DE SORTIE STATIQUE DE SECURITE**
STATISCHE SICHERE AUSGABESTUFE
STATIC SECURE OUTPUT STAGE

(30) Priorité: 02.06.2003 FR 0306626
(43) Date de publication de la demande: 01.03.2006
(73) Titulaire: Honeywell, 91190 Saint Aubin (FR)
(72) Inventeur: CARNICELLI, Vito, F-38170 Seyssinet-Pariset (FR); LENOIR, Jean-Christophe, F-38410 Vaulnaveys Le Haut (FR); SIMON, Jean-Luc, F-38100 Grenoble (FR); BOUTEILLE, Jean-Michel, F-38770 La Motte D'Aveillans (FR)
(74) Mandataire: Hecké, Gérard
(86) Numéro de dépôt international: PCT/FR2004/001344
(87) Numéro de publication internationale: WO 2004/109918

(56) Documents cités:
- WO-A-01/91278
- DE-A- 3 246 385
- DE-A- 3 905 163
- US-A- 4 890 183

## Description

### Domaine technique de l'invention

L'invention concerne un étage de sortie statique de sécurité comportant un montage de type push-pull constitué par des premier et second transistors complémentaires, connectés en série aux bornes d'une tension d'alimentation, et par une charge connectée à un point milieu, commun aux deux transistors, un circuit de contrôle connecté à des électrodes de commande des premier et second transistors comportant des moyens de test de l'étage de sortie par impulsions fines.

### État de la technique

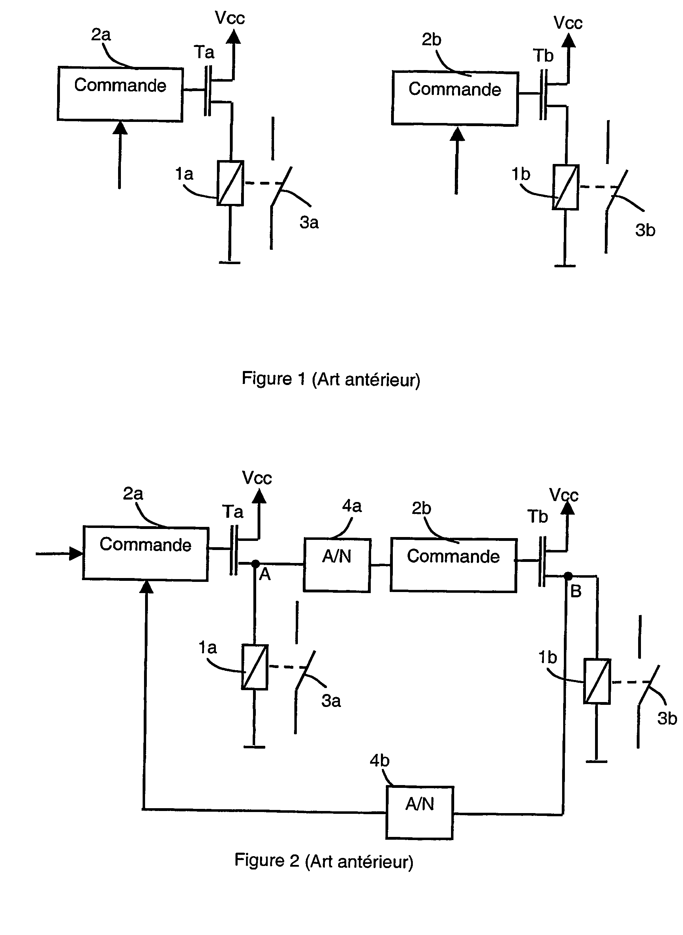

Un étage de sortie d'une unité de traitement, d'un automate ou d'un capteur comporte classiquement (figure 1) un transistor T connecté en série avec une charge 1 aux bornes d'une tension d'alimentation Vcc. La charge 1 peut, par exemple, être constituée par un relais 1. Un circuit de commande 2, par exemple connecté à un organe de détection (non représenté), applique en permanence à une électrode de commande du transistor T des signaux continus, rendant le transistor normalement conducteur, de manière à ce que le relais 1 soit alimenté en permanence.

À titre d'exemple, le circuit de commande 2 bloque le transistor T lorsqu'une intrusion détectée par le capteur doit provoquer l'interruption d'une machine, de manière à assurer la sécurité d'un utilisateur de cette machine. Le blocage du transistor T provoque l'interruption de l'alimentation du relais 1 par la tension d'alimentation Vcc et, en conséquence, la fermeture ou l'ouverture d'un interrupteur 3 contrôlé par le relais 1. Afin de garantir la sécurité de la fonction réalisée, deux voies de sortie redondantes sont utilisées, comme représenté à la figure 1. Deux circuits de commande 2a et 2b sont alors respectivement associés à des transistors Ta et Tb, respectivement connectés en série avec des relais 1 a et 1 b, contrôlant des interrupteurs 3a et 3b.

Pour améliorer la sécurité, il est connu, comme représenté à la figure 2, de coupler les deux voies de sortie, en appliquant l'image du signal de sortie de l'une des voies à une entrée du circuit de commande 2 de l'autre voie et réciproquement. Ainsi, le point A commun au transistor Ta et au relais 1a est connecté à l'entrée du circuit de commande 2b, par l'intermédiaire d'un convertisseur analogique-numérique 4a. De manière analogue, le point B commun au transistor Tb et au relais 1 b est connecté à une seconde entrée du circuit de commande 2a, par l'intermédiaire d'un convertisseur analogique-numérique 4b. Par ailleurs l'étage de sortie peut, de manière connue, être testé au moyen d'impulsions fines, appliquées par le circuit de commande 2a sur l'électrode de commande du transistor Ta. Ce type de test permet à un circuit de traitement, fournissant les impulsions de test et vérifiant la tension aux points A et B, de vérifier la capacité des transistors Ta et Tb à se bloquer, sans influencer le fonctionnement des relais 1 a et 1 b en raison de l'inertie de ceux-ci. Il est ainsi possible de détecter un court-circuit permanent de l'un des transistors, qui empêcherait l'interruption du courant dans le relais correspondant. Cependant, en cas de défaut du transistor Tb, un courant de fuite suffisant, par exemple de quelques mA pour un courant nominal de l'ordre de 500mA, peut conduire le circuit de traitement à une mauvaise interprétation des résultats d'un test par impulsions fines et empêcher la détection d'un mauvais fonctionnement du transistor Tb.

Par ailleurs, un court-circuit simultané des deux transistors n'est pas détecté par ce type de test dans les étages de sortie décrits ci-dessus.

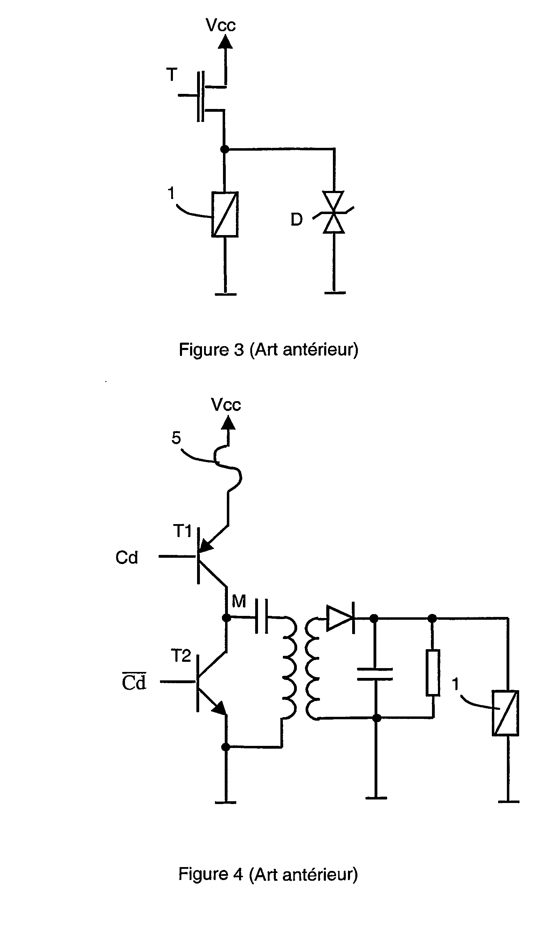

Il est également classique de prévoir un élément de protection en tension d'un transistor de sortie T, connecté en parallèle sur la charge. Cet élément de protection peut, par exemple, comme représenté à la figure 3, être constitué par une diode D, de type transil, ou par une varistance ("GEMOV") connectée en parallèle sur le relais 1. Des problèmes apparaissent néanmoins en cas d'absence de l'élément de protection, de mauvais branchement de celui-ci et d'onde de choc trop importante.

Certains étages de sortie comportent deux transistors connectés en série avec le relais 1 entre la tension d'alimentation Vcc et la masse. Dans ce type de montage, les deux transistors peuvent néanmoins être détruits simultanément par une onde de choc trop importante. Dans le document DE-A-3246385 notamment, un étage de sortie comporte deux transistors connectés en série avec un relais auxiliaire, qui n'est actionné que lorsque les deux transistors sont simultanément conducteurs. Le point commun aux deux transistors est polarisé par deux résistances et sa tension est surveillée par un discriminateur à fenêtre, qui fournit une tension continue à une diode de signalisation lorsque l'un des transistors est défectueux. Une défaillance simultanée des deux transistors ne peut être détectée.

Actuellement, l'étage de sortie le plus sûr comporte, comme représenté à la figure 4, un montage de type push-pull, constitué par la connexion en série, entre la tension d'alimentation Vcc et la masse, de deux transistors T1 et T2 complémentaires. L'un des transistors (T1), de type PNP, est commandé par un signal de commande Cd, tandis que le transistor complémentaire (T2), de type NPN, est commandé par un signal complémentaire C̅d̅. Les deux transistors sont donc commandés alternativement. Le relais 1 est connecté entre un point milieu M, commun aux deux transistors, et la masse, par l'intermédiaire d'un condensateur, d'un transformateur et d'un circuit de redressement et filtrage. La protection est assurée par un fusible 5, disposé en série avec les deux transistors, qui fond si un des transistors étant détruit, le second se met en court-circuit. Les deux transistors doivent, de plus, être de bonne qualité et appairés.

### Objet de l'invention

L'invention a pour but de remédier aux inconvénients des étages de sortie des dispositifs connus et, plus particulièrement, d'améliorer leur sécurité et leur disponibilité.

Selon l'invention, ce but est atteint par un étage de sortie selon les revendications annexées et plus particulièrement par le fait que le point milieu est polarisé à une tension de polarisation, par exemple de l'ordre de la moitié de la tension d'alimentation, et connecté à la charge par l'intermédiaire d'un troisième transistor ayant une électrode de commande connectée au circuit de contrôle, les moyens de test du circuit de contrôle fournissant des signaux de commande aptes à provoquer le blocage du troisième transistor pendant une phase de test.

Selon un développement de l'invention, le circuit de contrôle comporte des moyens de comparaison de la tension au point milieu au moins avec des premier et seconds seuils de tension, inférieurs à la tension de polarisation, et avec des troisième et quatrième seuils de tension, supérieurs à la tension de polarisation, les seconds et troisième seuils de tension étant proches de la tension de polarisation.

Selon un autre développement de l'invention, l'étage de sortie comporte un transformateur d'impulsions avec un enroulement primaire connecté en série avec un cinquième transistor ayant une électrode de commande connectée au circuit de contrôle, le transformateur comportant un premier enroulement secondaire fournissant les signaux de commande du troisième transistor.

Selon un autre développement de l'invention, l'étage de sortie comporte une résistance de shunt, connectée entre le point milieu et le troisième transistor, un sixième transistor, connecté en parallèle sur le premier enroulement secondaire du transformateur et commandé par la tension aux bornes de la résistance de shunt, et un second enroulement secondaire du transformateur, connecté à des entrées d'un amplificateur différentiel fournissant, le cas échéant, un signal de détection de surcharge au circuit de contrôle.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 4 illustrent divers étages de sortie selon l'art antérieur.
La figure 5 représente un mode de réalisation particulier d'un étage de sortie selon l'invention.
Les figures 6 à 8 illustrent diverses variantes de l'étage de sortie selon la figure 5.

### Description de modes particuliers de réalisation.

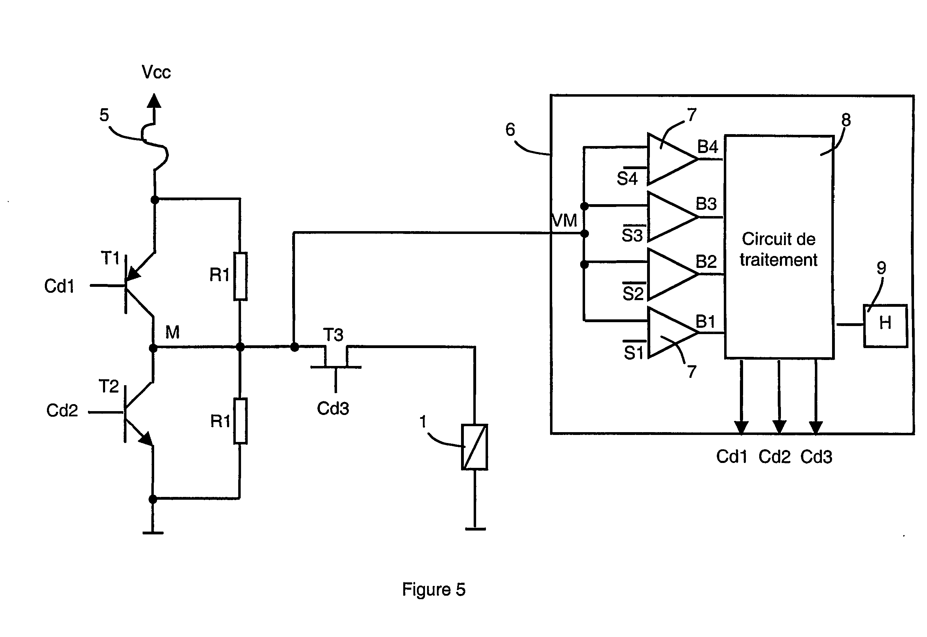

L'étage de sortie de la figure 5 comporte, comme celui de la figure 4, un montage de type push-pull, constitué classiquement par la connexion en série, aux bornes de la tension d'alimentation, c'est-à-dire entre Vcc et la masse ou entre +Vcc et -Vcc, de deux transistors T1 et T2 complémentaires, respectivement de type PNP et NPN. Le point milieu M, commun aux deux transistors, est polarisé à une tension de polarisation, par exemple de l'ordre de Vcc/2. Sur la figure 5, cette polarisation est réalisée par l'intermédiaire d'un diviseur résistif à haute impédance, comportant deux résistances R1, respectivement connectées entre la tension d'alimentation Vcc et le point milieu M et entre le point milieu M et la masse. Le point milieu M est connecté à la charge, constituée par le relais 1, par l'intermédiaire d'un transistor T3, par exemple de type MOS.

Les transistors T1 à T3 sont respectivement commandés par des signaux de test Cd1, Cd2 et Cd3, qui sont appliqués sur leurs électrodes de commande respectives par un circuit de contrôle 6, permettant notamment de tester l'étage de sortie. Le circuit de contrôle 6 peut être constitué par un microprocesseur et/ou des réseaux de portes programmables (FPGA), synchronisé par un circuit d'horloge 9 (H).

Pour interdire la commande simultanée des deux transistors T1 et T2, qui entraînerait un court-circuit de l'alimentation et, en conséquence, la destruction des composants, une période de blocage est systématiquement prévue, pendant une période de transition, avant tout signal de conduction. Ainsi, une phase de conduction de T1 (Cd1=0) ou de T2 (Cd2=1) est toujours précédée et suivie d'une phase de blocage des deux transistors T1 et T2 (Cd1=1 et Cd2=0).

Le test de l'étage de sortie est réalisé sous la forme d'impulsions fines, par exemple de durée inférieure à 200 µs, fournies par le circuit de contrôle et venant se superposer à des signaux de commande représentatifs de signaux de mesure appliqués à l'étage de sortie.

Lors d'un test, un circuit de traitement 8 du circuit de contrôle 6 analyse la tension VM du point milieu M en fonction des signaux de test Cd1, Cd2 et Cd3. Dans le mode de réalisation particulier de la figure 5, la tension du point milieu M est appliquée aux premières entrées de 4 comparateurs 7 constituant un convertisseur analogique-numérique. Chaque comparateur 7 comporte une seconde entrée, respectivement connectée à une tension de référence associée, définissant ainsi 4 seuils distincts S1, S2, S3 et S4, auxquels est comparée la tension du point milieu M. Les seuils S1 et S2 sont inférieurs à Vcc/2, tandis que les seuils S3 et S4 sont supérieurs à Vcc/2. Les seuils S1 et S4 sont respectivement très inférieur et très supérieur à Vcc/2, par exemple de l'ordre de Vcc/4 et 3Vcc/4, tandis que les seuils S2 et S3 sont très proches de Vcc/2, par exemple respectivement égal à (Vcc/2)-ε et (Vcc/2)+ε, étant la précision souhaitée sur le courant de fuite. Les tensions de seuil sont, de préférence, obtenues au moyen d'un diviseur de tension connecté entre la tension d'alimentation Vcc et la masse. Les tensions de seuil sont alors automatiquement ajustées lorsque la tension d'alimentation varie. La tension VM du point milieu M peut ainsi être analysée sur 4 bits B1, B2, B3 et B4, constitués par les signaux de sortie des 4 comparateurs 7 et représentatifs de l'état de l'étage de sortie.

En fonctionnement normal, le transistor T3, par exemple de type PMOS, est conducteur (Cd3=0) et le point milieu M est connecté à la charge constituée par le relais 1. Le circuit de contrôle 6 bloque périodiquement le transistor T3 (Cd3=1), de manière à isoler temporairement le point milieu M de la charge.

Pendant une phase de test, le transistor T3 est bloqué (Cd3=1), isolant le point M de la charge 1. Si les transistors T1 et T2 sont tous deux bloqués (Cd1=1 et Cd2=0), la tension VM au point milieu M est normalement égale à la tension de polarisation Vcc/2, c'est-à-dire comprise entre les seuils S2 et S3, soit entre (Vcc/2)-ε et (Vcc/2)+ε. Dans ce cas, si les premières entrées des comparateurs 7 sont des entrées positives, tandis que leurs secondes entrées, connectées aux tensions de référence, sont des entrées négatives, alors B1=B2=1 et B3=B4=0. Si ce n'est pas le cas, ceci est interprété par le circuit de contrôle 6 comme un défaut de l'étage de sortie. Si la tension VM au point milieu M est supérieure au seuil S4, c'est-à-dire si B1=B2=B3=B4=1, cela signifie que le transistor T1 est en court-circuit. De manière analogue, si la tension au point milieu M est inférieure au seuil S1, c'est-à-dire si B1=B2=B3=B4=0, cela signifie que le transistor T2 est en court-circuit. Si la tension VM au point milieu M est comprise entre les seuils S3 et S4, c'est-à-dire si B1=B2=B3=1 et si B4=0, ceci signifie que le transistor T1 présente un courant de fuite supérieur à une valeur prédéterminée acceptable, par exemple de 2mA pour un courant nominal qui peut atteindre 500mA. De même, si la tension VM au point milieu M est comprise entre S1 et S2, c'est-à-dire si B1=1 et si B2=B3=B4=0, ceci signifie que le transistor T2 présente un courant de fuite supérieur à une valeur prédéterminée acceptable. Ainsi, le montage constitué par les transistors T1 à T3 peut être analysé de manière très fine par une numérisation sur 4 bits, B1 à B4, lorsque le transistor T3 est bloqué de manière à isoler les transistors T1 et T2 de la charge 1.

Le bon fonctionnement des transistors T1 et T2 lorsque l'un ou l'autre est conducteur est également testé par impulsions fines par le circuit de contrôle pendant que le transistor T3 est conducteur (Cd3=0). Pour cela, le circuit de contrôle vérifie que la tension VM au point milieu M est supérieure au seuil S4 (B1=B2=B3=B4=1) lorsque le transistor T1 est conducteur (Cd1=0) et inférieure au seuil S1 (B1=B2=B3=B4=0) lorsque le transistor T2 est conducteur (Cd2=1).

Si le transistor T3 est en court-circuit pendant une phase de test (Cd3=1), la charge 1 est en permanence connectée au point M, provoquant un déséquilibre en ce point. Cet état peut alors être détecté par le circuit de traitement 6 car la tension VM n'est alors pas égale à Vcc/2 lorsque les deux transistors T1 et T2 sont bloqués.

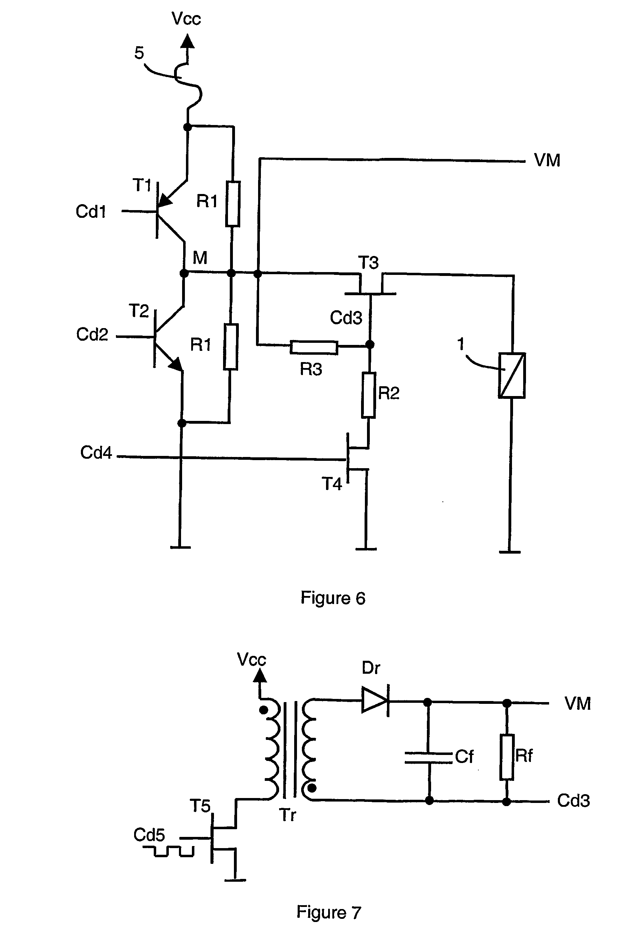

Comme représenté à la figure 6, le transistor T3 est, de préférence, commandé par l'intermédiaire d'un transistor T4, par exemple de type NMOS ou NPN, dont le drain est connecté par une résistance R2 à la grille du transistor T3 et dont la source est connectée à la masse. Une résistance de polarisation R3 est connectée entre le point milieu M et la grille du transistor T3. En fonctionnement normal, un signal de commande Cd4, de valeur binaire 1, est appliqué par le circuit de contrôle 6 sur la grille du transistor T4, celui-ci est conducteur et le signal de commande Cd3 est à 0, maintenant le transistor T3 conducteur. Pendant une phase de test, le signal de commande Cd4 passe à zéro et bloque le transistor T4, faisant ainsi passer le signal de commande Cd3 à 1 et bloquant le transistor T3.

L'étage de sortie décrit ci-dessus ne permet cependant pas de détecter une défaillance du circuit de contrôle 6, par exemple l'arrêt du circuit d'horloge 9. La variante illustrée à la figure 7 permet de surmonter cet inconvénient. Dans cette variante, le signal de commande Cd3 est généré par l'intermédiaire d'un convertisseur continu-continu isolé. Ce convertisseur comporte un transformateur d'impulsions Tr comportant un enroulement primaire connecté en série avec un transistor T5 entre la tension d'alimentation Vcc et la masse. Un enroulement secondaire du transformateur Tr fournit le signal de commande Cd3 du transistor T3, après redressement et filtrage, par exemple par une diode Dr et un condensateur de filtrage Cf et, éventuellement, une résistance de filtrage Rf, Cf et Rf étant connectés en parallèle sur le circuit série constitué par l'enroulement secondaire et la diode Dr. En fonctionnement normal, le signal de commande Cd5 est constitué par des impulsions, dérivées des signaux de sortie du circuit d'horloge 9 et ayant, par exemple, un rapport cyclique de 0,5 et une fréquence de l'ordre de 1,25MHz, générant ainsi un signal Cd3 continu provoquant la conduction du transistor T3 et, en conséquence, la connexion de la charge 1 au point milieu M. Cette variante permet ainsi de vérifier le dynamisme de la commande Cd5.

Pendant une phase de test, le circuit de contrôle 6 interrompt l'application des impulsions sur la grille du transistor T5, bloquant ainsi le transistor T3 et isolant la charge 1 du point milieu M. De même, la charge est automatiquement isolée du point milieu M en cas de défaillance du circuit d'horloge 9. Ceci améliore donc la sécurité de l'étage de sortie.

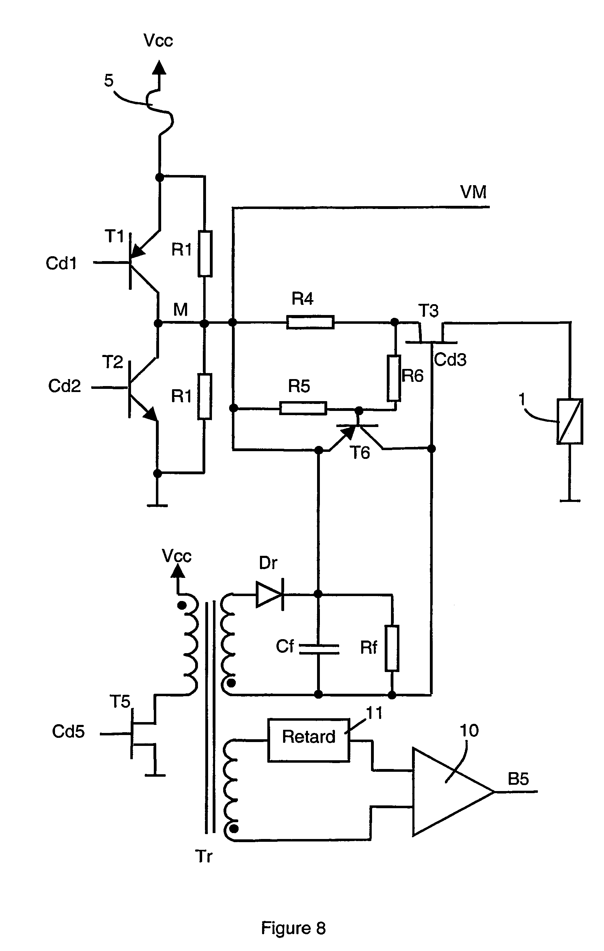

Comme sur la figure 4, un fusible 5 peut être utilisé pour protéger l'étage de sortie en cas de court-circuit aux bornes de la charge 1. Dans la variante illustrée à la figure 8, une résistance de shunt R4, de faible valeur (par exemple quelques ohms), connectée entre le point milieu M et le transistor T3, est utilisée pour détecter une surcharge et interrompre directement la commande de l'étage de sortie le temps que le traitement de commande s'arrête (Cd1=1 et Cd2=Cd5=0). La résistance de shunt R4 est associée à un second enroulement secondaire du transformateur Tr, connecté, respectivement directement et par l'intermédiaire d'un circuit de retard 11, à des première et seconde entrées d'un amplificateur différentiel 10. Un transistor T6, par exemple de type PNP, est connecté entre le point milieu M et l'électrode de commande du transistor T3, en parallèle sur la résistance de filtrage Rf. L'électrode de commande du transistor T6 est connectée au point milieu d'un diviseur de tension, connecté en parallèle sur la résistance de shunt R4 et comportant deux résistances R5 et R6.

En cas de court-circuit aux bornes de la charge 1, le courant circulant dans la résistance de shunt R4 provoque aux bornes de celle-ci une chute de tension suffisante pour rendre conducteur le transistor T6, normalement bloqué, bloquant ainsi le transistor T3, ce qui permet de limiter rapidement le courant de surcharge. Simultanément, la conduction du transistor T6 court-circuite le premier enroulement secondaire du transformateur Tr, ce qui provoque la chute de la tension aux bornes de l'enroulement primaire et, par conséquent aux bornes du second enroulement secondaire du transformateur Tr. Cette chute de tension aux bornes du second enroulement secondaire est automatiquement détectée par l'amplificateur différentiel 10, qui fournit alors un signal B5 de détection de surcharge au circuit de contrôle 6. Cette détection automatique isolée d'une surcharge permet de réaliser une autoprotection de l'étage de sortie. Dans un mode de réalisation particulier, lors de la réception d'un signal B5 de détection de surcharge, le circuit de contrôle 6 , après un délai de filtrage de l'ordre de 500µs, provoque le blocage des transistors T1, T2 et T3 par l'intermédiaire de signaux de commande Cd1, Cd2 et Cd5 appropriés. Pour réactiver les transistors T1, T2 ou T3, il est nécessaire d'effectuer une mise hors tension de l'étage de sortie, puis une remise sous tension après suppression du court-circuit ou de la surcharge. Avec un montage de ce type, aucun des composants n'aura à supporter des courants élevés et les transistors T1 et T2 n'ont pas besoin d'être appairés, ce qui permet de réduire le coût de l'étage de sortie malgré l'augmentation du nombre de composants.

Le circuit de contrôle 6 reçoit ainsi à tout instant des informations représentatives de l'état et du bon fonctionnement de l'étage de sortie et de la charge qui y est connectée, prenant en compte tous les modes de défaillance susceptibles d'affecter les différents composants. Il est ainsi possible d'assurer un niveau élevé de sécurité à coût réduit.

La tension au point milieu (M) peut être comparée à plus de 4 seuils de tension, permettant ainsi un codage sur plus de 4 bits.

## Revendications

1. Étage de sortie statique de sécurité comportant un montage de type push-pull constitué par des premier et second transistors (T1, T2) complémentaires, connectés en série aux bornes d'une tension d'alimentation, et par une charge (1) connectée à un point milieu (M), commun aux deux transistors, un circuit de contrôle (6) connecté (Cd1, Cd2) à des électrodes de commande des premier et second transistors (T1, T2) comportant des moyens de test de l'étage de sortie par impulsions fines, étage de sortie **caractérisé en ce que** le point milieu (M) est polarisé à une tension de polarisation et connecté à la charge (1) par l'intermédiaire d'un troisième transistor (T3) ayant une électrode de commande connectée au circuit de contrôle (6), les moyens de test du circuit de contrôle fournissant des signaux de commande (Cd3) aptes à provoquer le blocage du troisième transistor (T3) pendant une phase de test.

2. Étage de sortie selon la revendication 1, **caractérisé en ce que** la tension de polarisation est de l'ordre de la moitié de la tension d'alimentation.

3. Étage de sortie selon l'une des revendications 1 et 2, **caractérisé en ce que** le circuit de contrôle (6) comporte des moyens (7) de comparaison de la tension au point milieu (M) au moins avec des premier et seconds seuils (S1, S2) de tension, inférieurs à la tension de polarisation, et avec des troisième et quatrième seuils (S3, S4) de tension, supérieurs à la tension de polarisation, les seconds et troisième seuils (S2, S3) de tension étant proches de la tension de polarisation (Vcc/2).

4. Étage de sortie selon l'une quelconque des revendications 1 à 3, **caractérisé en ce qu'**il comporte un quatrième transistor (T4) connecté entre la masse et l'électrode de commande du troisième transistor (T3) et ayant une électrode de commande connectée à une sortie (Cd4) du circuit de contrôle (6).

5. Étage de sortie selon l'une quelconque des revendications1 à 4, **caractérisé en ce qu'**il comporte un transformateur d'impulsions (Tr) avec un enroulement primaire connecté en série avec un cinquième transistor (T5) ayant une électrode de commande connectée (Cd5) au circuit de contrôle (6), le transformateur (Tr) comportant un premier enroulement secondaire fournissant les signaux de commande (Cd3) du troisième transistor (T3).

6. Étage de sortie selon la revendication 5, **caractérisé en ce qu'**il comporte des moyens (Dr, Cf, Rf) de redressement et de filtrage à la sortie du premier enroulement secondaire du transformateur (Tr).

7. Étage de sortie selon l'une des revendications 5 et 6, **caractérisé en ce qu'**il comporte une résistance de shunt (R4), connectée entre le point milieu (M) et le troisième transistor (T3), un sixième transistor (T6), connecté en parallèle sur le premier enroulement secondaire du transformateur (Tr) et commandé par la tension aux bornes de la résistance de shunt (R4), et un second enroulement secondaire du transformateur, connecté, respectivement directement et par l'intermédiaire d'un circuit de retard (11), à des première et seconde entrées d'un amplificateur différentiel (10) fournissant, le cas échéant, un signal (B5) de détection de surcharge au circuit de contrôle (6).

8. Étage de sortie selon la revendication 7, **caractérisé en ce que** le circuit de contrôle (6) comporte des moyens (Cd1, Cd2, Cd3) pour bloquer les premier, second et troisième transistors (T1, T2, T3) en réponse à un signal (B5) de détection de surcharge.

## Claims

1. Static secure output stage comprising a push-pull type assembly constituted by complementary first and second transistors (T1, T2) connected in series to the terminals of a supply voltage, and by a load (1) connected to a mid-point (M) common to the two transistors, a control circuit (6) connected (Cd1, Cd2) to control electrodes of the first and second transistors (T1, T2) comprising means for testing the output stage by fine pulses, a output stage **characterized in that** the mid-point (M) is biased to a bias voltage and connected to the load (1) by means of a third transistor (T3) having a control electrode connected to the control circuit (6), the means for testing the control circuit providing control signals (Cd3) able to turn off the third transistor (T3) during a testing phase.

2. The output stage according to claim 1, **characterized in that** the bias voltage is about a half the supply voltage.

3. The output stage according to one of claims 1 and 2, **characterized in that** the control circuit (6) comprises means (7) for comparing the voltage at the mid-point (M) with at least first and second voltage thresholds (S1, S2), lower than the bias voltage, and with third and fourth voltage thresholds (S3, S4), higher than the bias voltage, the second and third voltage thresholds (S2, S3) being close to the bias voltage (Vcc/2).

4. The output stage according to any one of claims 1 to 3, **characterized in that** it comprises a fourth transistor (T4) connected between ground and the control electrode of the third transistor (T3) and having a control electrode connected to an output (Cd4) of the control circuit (6).

5. The output stage according to any one of claims 1 to 4, **characterized in that** it comprises a pulse transformer (Tr) with a primary winding connected in series with a fifth transistor (T5) having a control electrode connected (Cd5) to the control circuit (6), the transformer (Tr) comprising a first secondary winding providing the control signals (Cd3) of the third transistor (T3).

6. The output stage according to claim 5, **characterized in that** it comprises rectifying and filtering means (Dr, Cf, Rf) on output of the first secondary winding of the transformer (Tr).

7. The output stage according to one of claims 5 and 6, **characterized in that** it comprises a shunt resistor (R4) connected between the mid-point (M) and the third transistor (T3), a sixth transistor (T6) connected in parallel on the first secondary winding of the transformer (Tr) and controlled by the voltage at the terminals of the shunt resistor (R4), and a second secondary winding of the transformer connected respectively directly and via a delay circuit (11) to first and second inputs of a differential amplifier (10) providing, if applicable, an overload detection signal (B5) to the control circuit (6).

8. The output stage according to claim 7, **characterized in that** the control circuit (6) comprises means (Cd1, Cd2, Cd3) for turning off the first, second and third transistors (T1, T2, T3) in response to an overload detection signal (B5).

## Patentansprüche

1. Statische sichere Ausgabestufe, die eine Gegentakt Vorrichtung umfasst, die aus einem ersten und zweiten Transistor (T1, T2), die einander ergänzen und in Serie an die Klemmen einer Versorgungsspannung gelegt sind, und einer Ladung (1), die an einen beiden Transistoren gemeinsamen Mittelpunkt (M) gelegt ist, besteht, wobei eine Steuerschaltung (6), die an Steuerelektroden des ersten und zweiten Transistors (T1, T2) gelegt (Cd1, Cd2) ist, Mittel zum Testen der Ausgabestufe mittels schwacher Impulse umfasst, Ausgabestufe, die **dadurch gekennzeichnet ist, dass** der Mittelpunkt (M) auf eine Polarisationsspannung polarisiert und an die Ladung (1) mittels eines dritten Transistors (T3) gelegt ist, der eine an die Steuerschaltung (6) gelegte Steuerelektrode umfasst, wobei die Testmittel der Steuerschaltung Steuersignale (Cd3) liefern, die geeignet sind, während einer Testphase die Blockierung des dritten Transistors (T3) zu bewirken.

2. Ausgangsstufe nach Anspruch 1, **dadurch gekennzeichnet, dass** die Polarisationsspannung in etwa der halben Versorgungsspannung entspricht.

3. Ausgangsstufe nach einem der Ansprüche 1 und 2, **dadurch gekennzeichnet, dass** die Steuerschaltung (6) Mittel (7) zum Vergleich der Spannung am Mittelpunkt (M) mit mindestens einem ersten und einem zweiten Spannungsschwellenwert (S1, S2) umfasst, die niedriger als die Polarisationsspannung sind, sowie mit einem dritten und vierten Spannungsschwellenwert (S3, S4), die höher als die Polarisationsspannung sind, wobei der zweite und dritte Spannungsschwellenwert (S2, S3) nahe der Polarisationsspannung (Vcc/2) liegen.

4. Ausgangsstufe nach einem der Ansprüche 1 bis 3, **dadurch gekennzeichnet, dass** sie einen vierten Transistor (T4) umfasst, der zwischen die Masse und die Steuerelektrode des dritten Transistors (T3) gelegt ist und eine Steuerelektrode aufweist, die an einen Ausgang (Cd4) der Steuerschaltung (6) gelegt ist.

5. Ausgangsstufe nach einem der Ansprüche 1 bis 4, **dadurch gekennzeichnet, dass** sie einen Pulstransformator (Tr) mit einer Primärwicklung umfasst, der in Serie geschaltet ist mit einem fünften Transistor (T5), der eine Steuerelektrode hat, die an die Steuerschaltung (6) gelegt (Cd5) ist, wobei der Pulsgenerator (Tr) eine erste Sekundärwicklung umfasst, die die Steuersignale (Cd3) des dritten Transistors (T3) liefert.

6. Ausgangsstufe nach Anspruch 5, **dadurch gekennzeichnet, dass** sie am Ausgang der ersten Sekundärwicklung des Pulstransformators (Tr) Mittel (Dr, Cf, Rf) zur Gleichrichtung und Filterung aufweist.

7. Ausgangsstufe nach einem der Ansprüche 5 und 6, **dadurch gekennzeichnet, dass** sie einen Nebenwiderstand (R4) umfasst, der zwischen den Mittelpunkt (M) und den dritten Transistor (T3) geschaltet ist, einen sechsten Transistor (T6), der parallel zur ersten Sekundärwicklung des Pulstransformators (Tr) geschaltet ist und durch die Spannung an den Klemmen des Nebenwiderstands (R4) gesteuert wird, und eine zweite Sekundärwicklung des Pulstransformators, die jeweils direkt und mittels einer Verzögerungsschaltung (11) an einen ersten und einen zweiten Eingang eines Differenzialverstärkers (10) gelegt ist, der gegebenenfalls ein Signal (B5) an die Steuerschaltung (6) sendet, das das Entdecken einer Überlastung anzeigt.

8. Ausgangsstufe nach Anspruch 7, **dadurch gekennzeichnet, dass** die Steuerschaltung (6) Mittel (Cd1, Cd2, Cd3) zum Blockieren des ersten, zweiten und dritten Transistors (T1, T2, T3) als Reaktion auf ein Überlastungserfassungssignal (B5) umfasst.
